# EUROPEAN PATENT APPLICATION

(11) **EP 4 576 176 A1**
(43) Date of publication of application: **25.06.2025**
(21) Application number: 24214486.3
(22) Date of filing: 21.11.2024
(51) Int. Cl.: H01L 21/48, H01L 23/49, H01L 23/498, H01L 23/538, H05K 1/18, H01L 21/66, H01L 23/528

(54) **DOUBLE-SIDED INTEGRATED CIRCUIT PACKAGE APPARATUS AND RELATED METHODS**

(30) Priority: 22.12.2023 US 202318395317
(71) Applicant: INTEL Corporation, Santa Clara, CA 95054 (US)
(72) Inventor: FREIER, Joshua Dean, Portland, OR 97229 (US); POTHUKUCHI, Suresh Venkata, Chandler, AZ 85286 (US); NEVO, Ohad, HA 2708113 Kiriat Bialik (IL)
(74) Representative: HGF

(57) **Abstract**

Double-sided integrated circuit package apparatus and related methods are disclosed herein. An example apparatus includes an integrated circuit package including a die, and a package substrate having a first surface and a second surface opposite the first surface, the die coupled to the first surface, the first surface including a plurality of first contact pads and the second surface including a plurality of second contact pads, the first contact pads spaced apart from the die, the first contact pads and the second contact pads being electrically coupled with the die.

## Description

### FIELD OF THE DISCLOSURE

This disclosure relates generally to integrated circuit packages and, more particularly, to double-sided integrated circuit package apparatus and related methods.

### BACKGROUND

Integrated circuit (IC) chips and/or semiconductor dies are routinely connected to larger circuit boards such as motherboards and other types of printed circuit boards (PCBs) via a package substrate. Integrated circuit (IC) chips (e.g., dies, etc.) have exhibited reductions in size and increases in interconnect densities as technology has advanced.

### BRIEF DESCRIPTION OF THE DRAWINGS

FIG. 1 is an example integrated circuit (IC) package apparatus in accordance with teachings of this disclosure coupled to an example printed circuit board.
FIG. 2 is a cross-sectional view of the example IC package apparatus of FIG. 1.
FIG. 3 is a top view of the example IC package apparatus of FIG. 1.
FIG. 4 is a bottom view of the example IC package apparatus of FIG. 1.
FIG. 5 is a cross-sectional view of the example IC package apparatus of FIG. 1 coupled to the example printed circuit board in an example first orientation.
FIG. 6 is a cross-sectional view of the example IC package apparatus and the example printed circuit board of FIG. 5 in an example first testing condition.
FIG. 7 is a cross-sectional view of the example IC package apparatus of FIG. 1 coupled to the example printed circuit board in an example second orientation different than the example first orientation.
FIG. 8 is a cross-sectional view of the example IC package apparatus and the example printed circuit board of FIG. 7 in an example second testing condition.
FIG. 9 is a flowchart representing an example testing and/or debugging operation of the example IC package apparatus of FIGS. 1-8.
FIG. 10 is a flowchart representing an example manufacturing process for manufacturing the example package substrate of FIGS. 1-8.
FIGS. 11A-11F are cross-sectional views depicting the example package substrate of FIGS. 1-8 in various stages of manufacturing.

In general, the same reference numbers will be used throughout the drawing(s) and accompanying written description to refer to the same or like parts. The figures are not necessarily to scale. Instead, the thickness of the layers or regions may be enlarged in the drawings. Although the figures show layers and regions with clean lines and boundaries, some or all these lines and/or boundaries may be idealized. In reality, the boundaries and/or lines may be unobservable, blended, and/or irregular.

### DETAILED DESCRIPTION

Integrated circuit (IC) packages include multiple layers of materials that form transistors and/or interconnects for providing power and/or signal processing. For example, dies of IC packages include transistors at a surface of a semiconductor (e.g., silicon) substrate layer (e.g., a semiconductor wafer), and interconnects that power the transistors and transmit their data signals that are built above the transistors. Typically, the IC package and/or the die of the IC package can be coupled to a socket of a printed circuit board in a right-side up orientation to establish an electrical connection. Testing and/or debugging operations can be conducted with the IC package coupled to the socket of the printed circuit board in a right-side up orientation. In some examples, a layer (e.g., an upper layer or silicon layer of the IC package) can be machined and/or drilled to provide or form an access opening to enable access to the transistors and/or other components (e.g., metal interconnects) at various layers of the IC package to measure, obtain and/or otherwise detect signal(s), data and/or other electrical parameters associated with the dies (e.g., the transistors, etc.).

To improve power delivery needs and/or signal processing, some IC packages employ a backside power delivery configuration. The backside power delivery configuration moves the power-delivering interconnects from a first side of (e.g., above) the transistors to a second side of (e.g., beneath) the transistors of a die (e.g., on a side of the based semiconductor substrate (e.g., wafer) opposite to the transistors). In other words, data and/or signaling interconnects are positioned above the transistors and power interconnects are positioned beneath the transistors. To this end, a die of an IC package can be manufactured with more data interconnects, thereby increasing data and/or signaling capabilities and/or capacity. Additionally, power interconnects positioned beneath the transistors can be made larger and, therefore, less resistive. As a result, example IC packages having backside power delivery configurations an easier path for power to flow to a central processing unit (CPU), thereby enabling processor circuitry to experience less voltage droop and improve CPU performance. In other words, there is a smaller transient fall in voltage when demand for current increases from, for example, a large block of logic represented by the transistors switching on. With less voltage droop, transistors can operate faster and/or more efficiently. Additionally, a core die can be made more compact in size, decreasing a length of interconnects between logic cells, which improves speed. For example, lack of congestion allows some of the smallest interconnects to be spaced apart or spread out, reducing parasitic capacitance that hinders performance.

Typically, IC packages having backside power delivery configurations include backside metal routing and frontside metal routing that surround transistors. With metal routing on both sides of the transistors, traditional testing and/or debugging techniques cannot be employed. For instance, with backside metal technologies, including both power rail and signal routes, testing and/or debugging of backside metal dies often requires testing to be performed from both sides of the die and/or IC package. For example, openings are often machined on a frontside (e.g., a first side or top side) of a front side metal layer of a die and a backside (e.g., a bottom side) of the back metal layer of a die. Debugging using frontside metal can be limited because a hole needed to gain access to a lower-level metal signal(s) can be quite large in size and/or diameter. Thus, excavating through the package to access a backside metal and/or transistors risk damage such that an IC package will no longer function. To enable testing and/or debugging operations of IC packages having backside power delivery, interposers are often employed. For example, a die is attached to an interposer in an upside-down orientation relative to a socket of a circuit board. Thru-package debugging techniques employ specially designed interposers that mount to dies under testing. For example, most implementations of these interposers are solder on variety (SOInt). The interposer, with a die attached, is then mounted to other specially designed sockets and/or circuit boards (printed circuit boards) to enable electrical connectivity, testing and/or debug operations. Thus, a debugging operation employs orienting a die in an upright (e.g., a right-side up) orientation first, then attaching an interposer to the die to enable coupling the die to the socket and/or other circuit boards in an upside-down orientation. As used herein, a first orientation or right-side up orientation is an orientation in which a front surface of a die is oriented in a first or upward direction away from an upper surface of a circuit board. In contrast, as used herein, an upside-down orientation is an orientation in which the front surface of the die is oriented in a second or downward orientation opposite the first or upward direction such that the front surface of the die is oriented toward an interposer and/or the upper surface of the circuit board. In other words, the die is flipped one-hundred eighty degrees between the first orientation and the second orientation. The die in the second or die upside-down orientation cannot be flipped or returned to the first or die right-side up orientation later because the interposer cannot be removed without causing damage to the die. Attaching units to interposers incur additional thruput and/or assembly success rate challenges, which ultimately result is a slower than desired time for testing and/or debugging and which can increase risk of failure for units undergoing debugging operations. Traditional interposer solutions cost more to implement, have more hardware associated with them, and/or are overall more complex to use.

To facilitate testing and/or debugging of dies and/or IC packages, example apparatus and methods disclosed herein employ a double-sided package substrate. Example double-sided package substrate apparatus disclosed herein enable example package substrates and/or a die (e.g., an IC package) to be oriented in a first orientation (e.g., a right-side up orientation) and a second orientation (e.g., an upside-down orientation) different than the first orientation. In other words, example package substrates (e.g., die carriers) disclosed herein can be flipped (e.g., 180 degrees). As used herein, a double-sided IC package or package substrate means that a die and/or package substrate can be electrically coupled and/or physically attached to a socket and/or a circuit board in either a first or right-side up orientation or a second or upside-down orientation, without the use of an interposer or other intervening structures. For example, the double sided IC package can be flipped or rotated one-hundred eight degrees relative to a circuit board. For example, a double-sided package substrate disclosed herein can be coupled directly (electrically coupled) to a socket and/or circuit board in either a die up (e.g., a right-side up) configuration or a die down (e.g., an upside-down) configuration for signal probing, physical debugging and/or other testing or debugging operations. In a first, die-up or a die right-side up orientation, a front or upper surface of the die is oriented in a first direction relative to an upper surface of a printed circuit board when the package substrate is coupled to the printed circuit board. In contrast, in a second, die-down, or die upside-down orientation, the front or upper surface of the die is oriented in a second direction relative to the upper surface of the printed circuit board when the package substrate is coupled to the printed circuit board. For instance, the die is flipped or rotated 180 degrees to move the die between the first orientation and the second orientation., In some examples, the first orientation is an upright orientation and the second orientation is an upside down orientation. In some examples, the first orientation is a left-side orientation and the second orientation is a right-side orientation. In other words, the die can be mounted to a horizontally-oriented circuit board, or the die can be mounted to a vertically-oriented circuit board, and/or any other orientation of a circuit board. In some examples, in the first orientation, the die (e.g., in an upright orientation) extends from an opening of a socket of a printed circuit board. In some examples, in the second orientation, the die (e.g., an upside-down orientation) extends toward or through an opening of the socket of the printed circuit board.

To provide double-sided package substrate, example IC packages disclosed herein employ package substrates having electrical pads on both a top surface and a bottom surface of package layer for connecting to a socket and/or a printed circuit board. Fully planned and designed routing in the package layers enable the device to be functional regardless of the orientation (i.e., a die up orientation vs. a die down orientation) when coupled to a socket of a circuit board. Thus, an example package substrate disclosed herein includes electrical pads on a die side surface of a package substrate and a non-die side of the package substrate. Additionally, at least some of respective ones of the first contact pads on a first surface of the package substrate are electrically coupled to at least some of respective ones of the second contact pads on a second surface of the package substrate. In this manner, electrical connectivity can be completed in such a way that when the package substrate is flipped over (e.g., 180 degrees), the package substrate can operate in the same, or nearly the same manner as it would in its normal orientation. Example electrical pads disclosed herein could be configured for land grid array (LGA) sockets, ball grid array (BGA) sockets, pin grid array (PGA) sockets, or other types of socket technology and/or connection types.

A double-sided package substrate addresses challenges of testing and/or debugging by allowing testing and/or debugging operations of an IC package apparatus in either the die-up or die-down orientation without the need of a permanent attachment to another PCB using interposers, other intervening structures, etc. Additionally, eliminating the need for interposers reduces total throughput times, reduces yield risk associated with interposer attachment process, and/or reduces hardware costs by eliminating specialized interposers and associated hardware. Example apparatus and methods disclosed herein provide improved gas delivery during some unit prep activities, improve signal-to-noise ratios when gathering data with beam-based tools, and/or improve signal integrity of signaling between device package and a test interface unit (TIU) (e.g., test equipment, multimeters, etc.).

Example integrated circuit and/or semiconductor packages disclosed herein can be used with semiconductor dies or chiplets (e.g., tiles) that can implement controllers, microprocessors, Digital Signal Processors (DSPs), Central Processor Units (CPUs), Graphics Processor Units (GPUs), programmed microprocessors, Field Programmable Gate Arrays (FPGAs), Application Specific Integrated Circuits (ASICs), Reduced Instruction Set Computers (RISCs), any other circuitry and/or combinations thereof. Additionally, example IC packages disclosed herein can be used with chiplets of a disaggregated die. Each chiplet (also referred to as a tile) may implement a dedicated function. Together, the chiplets may implement a complex circuitry. The complex circuitry can be any type of device that can be implemented as a plurality of chiplets that are physically separated from, but communicatively coupled to, one another. For example, processor circuitry may be implemented by two or more separate chiplets that together implement a microprocessor, etc. Alternatively, in other examples, example IC packages disclosed herein may be different chips (e.g., a processor circuitry, a memory, and/or or some other type of component) that together implement a system on a chip (SoC) in a semiconductor package.

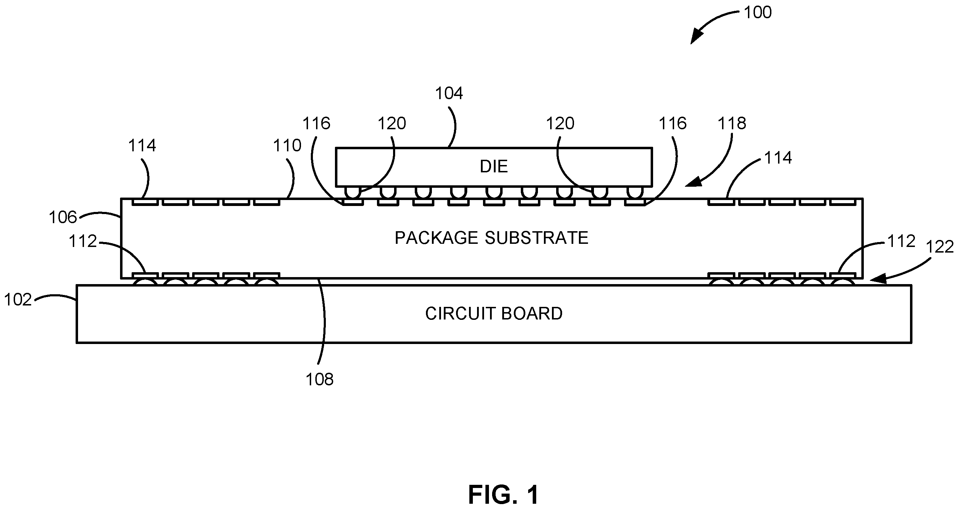

FIG. 1 illustrates an example integrated circuit (IC) package 100 (e.g., a semiconductor package, a package stack-up, etc.) constructed in accordance with teachings disclosed herein. In the illustrated example, the IC package 100 is electrically coupled to a circuit board 102. The IC package 100 of the illustrated example includes a semiconductor die 104 (e.g., silicon dies, chips or chiplets, etc.) coupled (e.g., mounted) to a package substrate 106. The die 104 can provide any suitable type of functionality (e.g., data processing, memory storage, etc.). In some examples, the die 104 can be enclosed by a package lid or mold compound.

The package substrate 106 of the illustrated example is provided for testing and/or debugging the die 104 and/or the IC package 100 prior to production of the die 104 and/or the IC package 100. The package substrate 106 of the illustrated example includes a first surface 108 (e.g., a first side or a bottom surface) and a second surface 110 (e.g., a second side or an upper surface) spaced from the first surface 108 (e.g., by a thickness in a z-direction or vertical direction). In the orientation of FIG. 1, the first surface 108 is a bottom surface of the package substrate 106 and the second surface 110 is an upper surface of the package substrate 106. The package substrate 106 of the illustrated example includes a plurality of first contact pads 112 (e.g., lands) provided (e.g., formed) on the first surface 108 of the package substrate 106 and a plurality of second contact pads 114 (e.g., lands) provided (e.g., formed) on the second surface 110 of the package substrate 106 opposite the first surface 108. Additionally, the package substrate 106 of the illustrated example includes a plurality of third contact pads 116 (e.g., lands) provided (e.g., formed) on the second surface 110 of the package substrate 106. The third contact pads 116 of the illustrated example are provided adjacent and/or between the second contact pads 114 (e.g., within a perimeter or area of the second contact pads 114). In some examples, the package substrate 106 can include balls, pins, and/or pads in addition to or instead of the first contact pads 112, the second contact pads 114 and/or the third contact pads 116.

In the illustrated example, the die 104 is electrically and mechanically coupled to the package substrate 106 via corresponding array of interconnects 118. In FIG. 1, the interconnects 118 are shown as bumps 120 (e.g., core bumps). Specifically, respective ones of the bumps 120 are coupled (e.g., soldered) to respective ones of the third contact pads 116 of the package substrate 106. Thus, the die 104 of the illustrated example is coupled to the second surface 110 of the package substrate 106. In other examples, the interconnects 118 may be any other type of electrical connection in addition to or instead of the bumps 120 shown (e.g., balls, pins, pads, wire bonding, etc.). The electrical connection between the die 104 and the package substrate 106 (e.g., via the interconnects 118) is sometimes referred to as first level interconnects. The first level interconnects establish communication and/or electrical paths between the die 104 and the package substrate 106. Thus, the third contact pads 116 and the bumps 120 of the illustrated example establish communication and/or electrical paths between the die 104 and the package substrate 106.

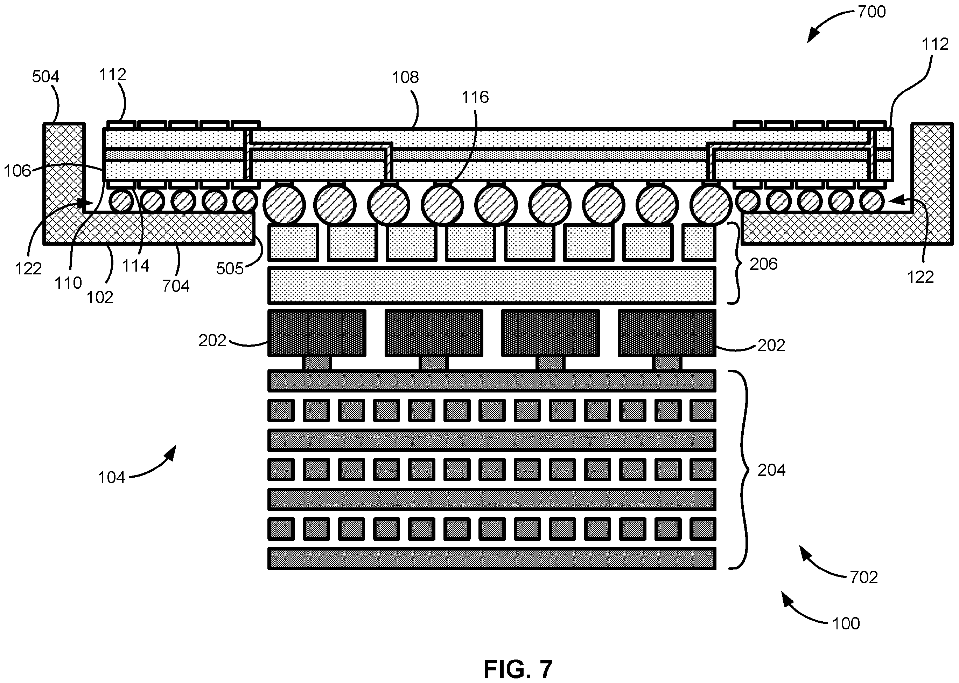

The electrical connections between the IC package 100 and the circuit board 102 is sometimes referred to as second level interconnects. The second level interconnects establish communication and/or electrical paths between the circuit board 102 and the package substrate 106 (e.g., and/or the die 104 via the package substrate 106). To enable the electrical coupling of the IC package 100 and the circuit board 102, the first contact pads 112 and the second contact pads 114 provide second level interconnects. Specifically, the package substrate 106 and/or the IC package 100 can couple to the circuit board 102 via the first contact pads 112 or the second contact pads 114. As described in greater detail below, during testing and/or debugging operations, the circuit board 102 and the die 104 can be communicatively and/or electrically coupled via either the first contact pads 112 and the third contact pads 116 when the IC package 100 is coupled to the circuit board 102 via the first contact pads 112 or the second contact pads 114 and the third contact pads 116 when the IC package 100 is coupled to the circuit board 102 via the second contact pads 114. In other words, the package substrate 106 of the illustrated example is a double-sided package substrate having second level interconnects on both sides of the package substrate 106. As described in greater detail below, the package substrate 106 and/or the IC package 100 can be rotated (e.g., one-hundred eight degrees) to enable connection with the circuit board 102 with either the first contact pads 112 or the second contact pads 114. The circuit board 102 includes a socket 122 for coupling to the first contact pads 112 or the second contact pads 114. In some examples, the socket 122 includes an opening that provides space for the die when the die is flipped over as shown, for example, in FIG. 7. The socket 122 can be a ball grid array (BGA) socket, a land grid array (LGA) socket, a pin grid array (PGA) socket, and/or any other type of socket(s) or connector(s). In the illustrated example, the first contact pads 112 and the second contact pads 114 are configured to couple to the socket 122 (e.g., the same type of socket). In other examples, the first contact pads 112 and/or the second contact pads 114 can be configured to couple to the socket 122. In some examples, the first contact pads 112 can be configured to couple to a first type of socket (e.g., a BGA socket) and the second contact pads 114 can be configured to couple to a second type of socket (e.g., a LGA socket).

While the example IC package 100 of FIG. 1 includes a single die, in other examples, the IC package 100 may have two or more dies. In some examples, the IC package 100 can include another die operatively and/or electrically coupled to the die via, for example, a bridge bump. For instance, bridge bumps pass electrical signals between different ones of the dies within an IC package. More particularly, bridge bumps differ from core bumps in that bridge bumps electrically connect two or more different dies via an interconnect bridge embedded in an underlying substrate (e.g., the package substrate 106). In some examples, a plurality of dies may be stacked on top of one or more other dies and/or an interposer. In such examples, the dies are coupled to the underlying die and/or interposer through a first set of first level interconnects and the underlying die and/or interposer may be connected to the package substrate 106 via a separate set of first level interconnects associated with the underlying die and/or interposer. Thus, as used herein, first level interconnects refer to interconnects (e.g., balls, bumps, pins, pads, wire bonding, etc.) between a die and a package substrate or a die and an underlying die and/or interposer. The second level interconnects refer to interconnects (e.g., balls, lands, pins, etc.) between the circuit board (e.g., a socket of the circuit board) and the package substrate.

Additionally, the printed circuit board 102 of FIG. 1 is shown in an example horizontal or flat orientation. While the printed circuit board 102 of FIG. 1 is shown in an example horizontal or flat orientation, in other examples, the printed circuit board 102 of FIG. 1 can be oriented in a vertical orientation and/or any other orientation (e.g., between the horizontal orientation and the vertical orientation). As used herein, a die and/or package substrate that can be flipped or oriented in a first orientation or a second orientation means that the die and/or package substrate can be rotated or flipped (e.g., 180 degrees) relative to the printed circuit board. To this end, in a first orientation, the die 104 projects in a first direction relative to (e.g., an upper surface of) the printed circuit board 102, and in a second orientation, the die 104 projects in a second direction relative to (e.g., the upper surface of) the printed circuit board 102 different than (e.g., opposite) the first direction.

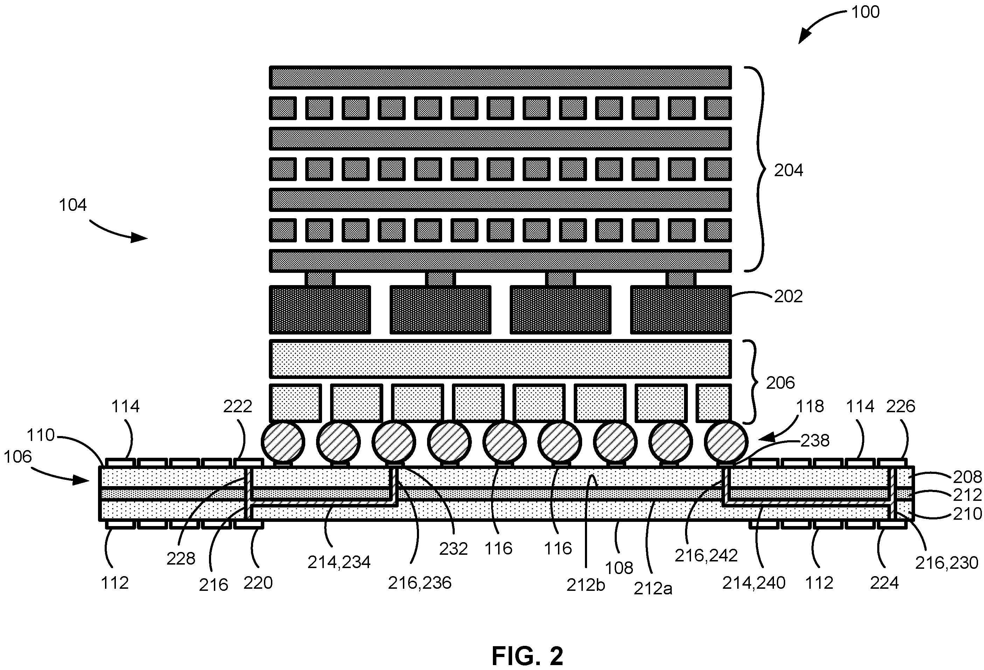

FIG. 2 is a cross-sectional view of the example IC package 100 (e.g., a semiconductor package) of FIG. 1. The die 104 of the illustrated example includes backside power delivery. The die 104 of the illustrated example includes a plurality of transistors 202 (e.g., p-type metal oxide semiconductor (PMOS) transistors, n-type metal oxide semiconductor (NMOS) transistors, etc.) positioned between first or frontside metal layers 204 and second or backside metal layers 206. For instance, the frontside metal layers 204 are on a first or front side of the die 104 and the backside metal layers 206 are on a second or back side of the die. The frontside metal layers 204 provide traces that define signal traces (e.g., signaling lines) to transfer signals or information between various components (e.g., transistors 202, capacitors, resistors, backend layers, etc. and/or other circuitry) of the IC package 100. The backside metal layers 206 provide traces that define power traces for transferring or carrying power to the IC package 100, including, for example, the transistors 202 and other various components (e.g., capacitors, resistors, backend layers, etc. and/or other circuitry). Thus, the frontside metal layers 204 provide data and/or signaling communication with the transistors 202 and the backside metal layers 206 provide power to the transistors 202. In the illustrated example, the interconnects 118 (e.g., the bumps 120) couple the backside metal layers 206 of the die 104 and the package substrate 106 via the third contact pads 116. Thus, the interconnects 118 electrically couple the die 104 and the package substrate 106.

The package substrate 106 of the illustrated example can include a plurality of layers including, for example, a first build-up layer 208, a second build-up layer 210 and a core layer 212. For example, the core layer 212 includes a first surface 212a (e.g., a first side) and a second surface (e.g., a second side) opposite the first surface 212a. The first build-up layer 208 can be provided on the first surface 212a of the core layer 212 and the second build-up layer 210 can be provided on the second surface 212b of the core layer 212 of the package substrate 106. The first and second build-up layers 208, 210 can include insulation or dielectric materials or layers and conductive materials or layers (e.g., patterned lithographically) to provide (e.g., form) the first contact pads 112 on the first surface 108 of the package substrate 106 and the second contact pads 114 and the third contact pads 116 on the second surface 110 of the package substrate 106 and/or traces 214 within the package substrate 106 (e.g., the first and second build-up layers 208, 210). Electrically conductive vias 216 (e.g., through substrate vias (TSV), through-glass vias (TGVs), copper plated vias, etc.) extend through the first and second build-up layers 208, 210 and/or the core layer 212 and electrically interconnect the traces 214 with the first contact pads 112, the second contact pads 114 and/or the third contact pads 116. Thus, the traces 214 and the vias 216 can be provided (e.g., formed) by the package substrate 106 (e.g., within the first and second build-up layers 208, 210 and/or the core layer 212).

The first and second build-up layers 208, 210 can include, but are not limited to, titanium dioxide (TiO₂), hafnium dioxide (HfO₂), hafnium zirconium oxide (HZO) (e.g., HZO film), and/or any other suitable dielectric material(s) (e.g., non-conducting material(s) that stores electrical charges). The traces 214 can be provided or formed of conductive layers that can be copper, gold, aluminum and/or any other electrically conductive material(s).

The core layer 212 can be a substrate composed of silicon or glass (e.g., a glass substrate or glass core aluminosilicate, borosilicate, alumino-borosilicate, silica, and/or fused silica). In some examples, the core layer 212 can include one or more additives including, but not limited to: aluminum oxide (Al2O3), boron trioxide (B2O3), magnesia oxide (MgO), calcium oxide (CaO), stoichiometric silicon oxide (SrO), barium oxide (BaO), stannic oxide (SnO2), nickel alloy (Na2O), potassium oxide (K2O), phosphorus trioxide (P2O3), zirconium dioxide (ZrO2), lithium oxide (Li2O), titanium (Ti), and/or zinc (Zn)). In some examples, the core layer 212 can include silicon and oxygen. In some examples, the core layer 212 can include silicon, oxygen and/or one or more of aluminum, boron, magnesium, calcium, barium, tin, sodium, potassium, strontium, phosphorus, zirconium, lithium, titanium, and/or zinc.

The package substrate 106 of the illustrated example includes a plurality of traces 214 and/or vias 216 (through-silicon vias (TSVs), through-glass vias (TGVs), etc.) to electrically couple the first contact pads 112, the second contact pads 114 and the die 104. For example, the vias 216 and/or the traces 214 provided by conductive layers in the package substrate 106 communicatively and/or electrically couple the first contact pads 112 and the second contact pads 114 with the third contact pads 116 (e.g., and/or the interconnects 118 of the die 104). In the illustrated example, the first contact pads 112 (e.g., at least some of the first contact pads 112) are electrically coupled to corresponding respective ones of the second contact pads 114. Additionally, respective ones of the first contact pads 112 and respective ones of the second contact pads 114 are coupled to respective ones of the third contact pads 116 (e.g., and/or the interconnects 118) via respective ones of the traces 214 and/or respective ones of the vias 216 provided (e.g., formed) in the package substrate 106. Therefore, communication with the die 104 can be established via the first contact pads 112 and/or the second contact pads 114.

For instance, a first respective one 220 of the first contact pads 112 is electrically coupled to a first respective one 222 of the second contact pads 114 via a first one 228 of the vias 216, and a second respective one 224 of the first contact pads 112 is electrically coupled to a second respective one 226 of the second contact pads 114 via a second one 230 of the vias 216. Additionally, a first one 232 of the third contact pads 116 is coupled to the first respective one 220 of the first contact pads 112 and the first respective one 222 of the second contact pads 114 by the first one 228 of the vias 216, a first trace 234 of the traces 214 and a third one 236 of the vias 216. Likewise, a second one 238 of the third contact pads 116 is coupled to the second one 224 of the first contact pads 112 and the second one 226 of the second contact pads 114 by the second one 230 of the vias 216, a second trace 240 of the traces 214 and a fourth one 242 of the vias 216.

Thus, in the illustrated example, each set or pair of electrically coupled first and second contact pads 112, 114 is coupled to a dedicated one of the third contact pads 116. Thus, the first respective one 220 of the first contact pads 112 and the first respective one 222 of the second contact pads 114 are electrically coupled to (e.g., are only electrically coupled to) the first one 232 of the third contact pads 116. Likewise, the second respective one 224 of the first contact pads 112 and the second respective one 226 of the second contact pads 114 are electrically coupled to (e.g., are only electrically coupled to) the second one 238 of the third contact pads 116. In other words, with the exclusion of the first one 232 of the third contact pads 116, the first respective one 220 of the first contact pads 112 and the first respective one 222 of the second contact pads 114 (e.g., a first set of electrically coupled contact pads) are electrically decoupled from (e.g., are not electrically coupled to or are electrically isolated from) other ones (e.g., the second one 238) of the third contact pads 116. However, in other examples, a set or pair of first and second contact pads 112, 114 (e.g., the first respective one 220 of the first contact pads 112 and the second respective one 226 of the second contact pads 114) can be coupled to two or more of the third contact pads 116 (e.g., the first one 232 of the third contact pads 116 and the second one 238 of the third contact pads 116).

In other examples, only some of the first contact pads 112 and some of the second contact pads 114 are communicatively and/or electrically coupled. For example, a first set of the first contact pads 112 is electrically coupled to a second set of the second contact pads 114. Respective ones of the first set of the first contact pads 112 are electrically coupled to respective ones of the second set of the second contact pads 114 by the traces 214 and/or the vias 216 (e.g. TSVs, TGVs, etc.) provided in the package substrate 106. The first set of first contact pads 112 and the second set of the second contact pads 114 are electrically coupled with the die 104 such that an electrical connection with the die 104 can be established via the first set of the first contact pads 112 or the second set of the second contact pads 114. In some examples, the first surface 108 of the package substrate 106 has a greater number of the first contact pads 112 than a number of second contact pads 114 provided on the second surface 110. In some examples, the first surface 108 of the package substrate 106 has a lesser number of the first contact pads 112 than a number of second contact pads 114 provided on the second surface 110. In some examples, the first surface 108 of the package substrate 106 has an equal number of the first contact pads 112 and the second contact pads 114. In some examples, not all of the first contact pads 112 are electrically connected to the second contact pads 114. In the illustrated example, at least some of the first contact pads 112 align (e.g., vertically) with at least some of the second contact pads 114. For example, the first one 220 of the first contact pads 112 aligns (e.g., vertically in the orientation of FIG. 2) with at least the first one 222 of the second contact pads 114, and the second one 224 of the first contact pads 112 aligns (e.g., vertically in the orientation of FIG. 2) with at least the second one 226 of the second contact pads 114. However, in other examples, the first contact pads 112 do not align (e.g., vertically) relative to the second contact pads 114.

The back metal layer 206 of the illustrated example couples the die 104 to the package substrate 106 via the interconnects 118. In operation, the interconnects 118 (e.g., core bumps 120) electrically couple the die 104 and the package substrate 106. The interconnects 118 pass electrical signals between the die and other components (e.g., other dies) within and/or external to the IC package 100. Thus, as shown in the illustrated example, when the die 104 is mounted to the package substrate 106, the interconnects 118 are physically connected and electrically coupled to the third contact pads 116 provided on the second surface 110 of the package substrate 106. As noted above, the third contact pads 116 on the second surface 110 of the package substrate 106 are electrically coupled to at least some of the first contact pads 112 on the first surface 108 of the package substrate 106 (e.g., a surface opposite the second surface 110) and the second contact pads 114 on the second surface 110 of the package substrate 106 (e.g., a surface opposite the first surface 108) via the traces 214 and/or the vias 216 within the package substrate 106. As a result, a complete signal path is provided between the interconnects 118 of the die 104 and the first contact pads 112 or the second contact pads 114 when mounted to the circuit board 102 that passes through the interconnects 118 provided therebetween.

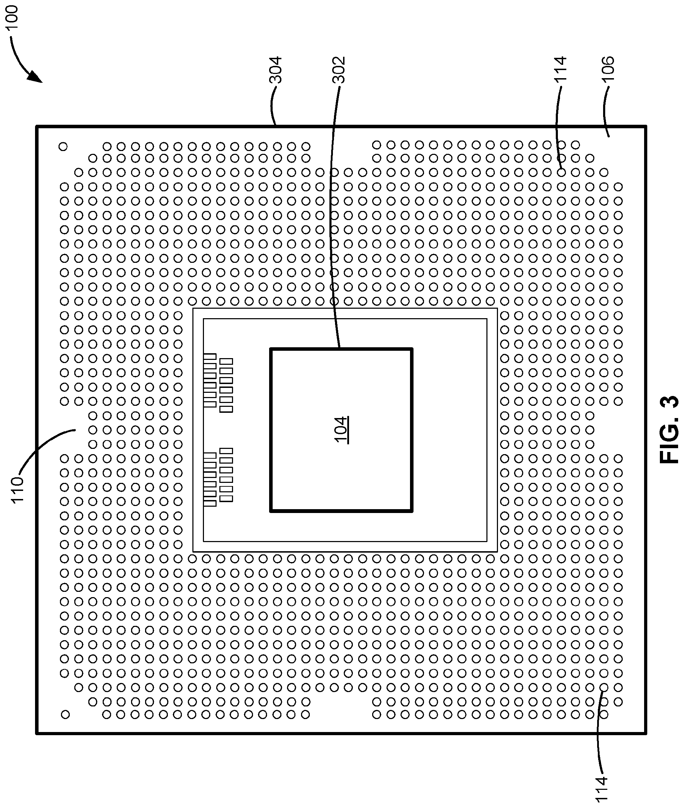

FIG. 3 is a top view of the IC package 100 of FIG. 1. As shown in FIG. 3, the second surface 110 of the package substrate 106 includes the second contact pads 114 (e.g., lands). The second contact pads 114 of the second surface 110 of the illustrated example extend between a perimeter edge 302 the die 104 and a perimeter edge 304 of the package substrate 106. In this example, the die 104 has a footprint that is substantially smaller than a footprint of the package substrate 106. In other words, the package substrate 106 has a perimeter and/or area that is greater than a perimeter and/or area of the die 104. As shown, the die 104 is positioned within the area defined by the package substrate 106. The second contact pads 114 of the illustrated example are electrically coupled to the die 104 via the traces 214 and/or the vias 216 provided in the package substrate 106 to enable electrical connectivity to the die 104.

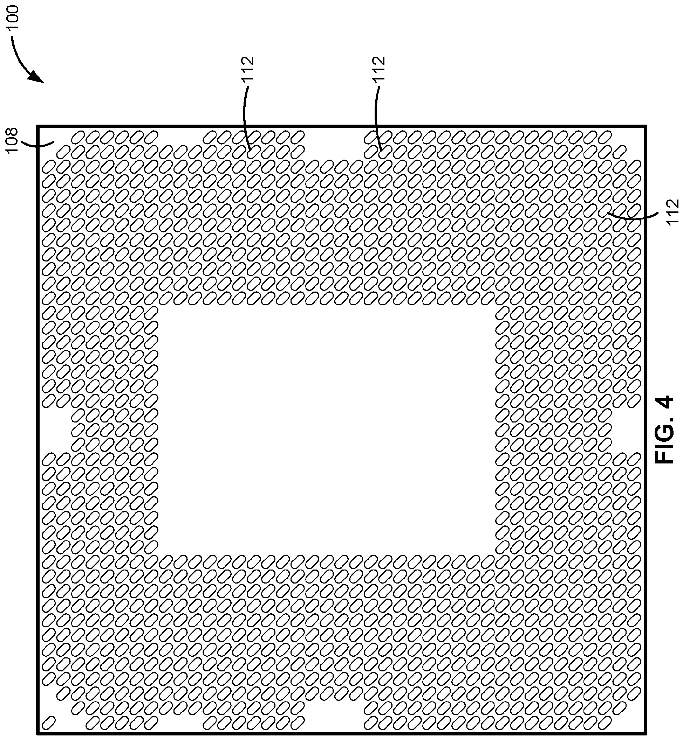

FIG. 4 is a bottom view of the IC package 100 of FIG. 1. As shown in FIG. 4, the first surface 108 of the package substrate 106 includes the first contact pads 112.

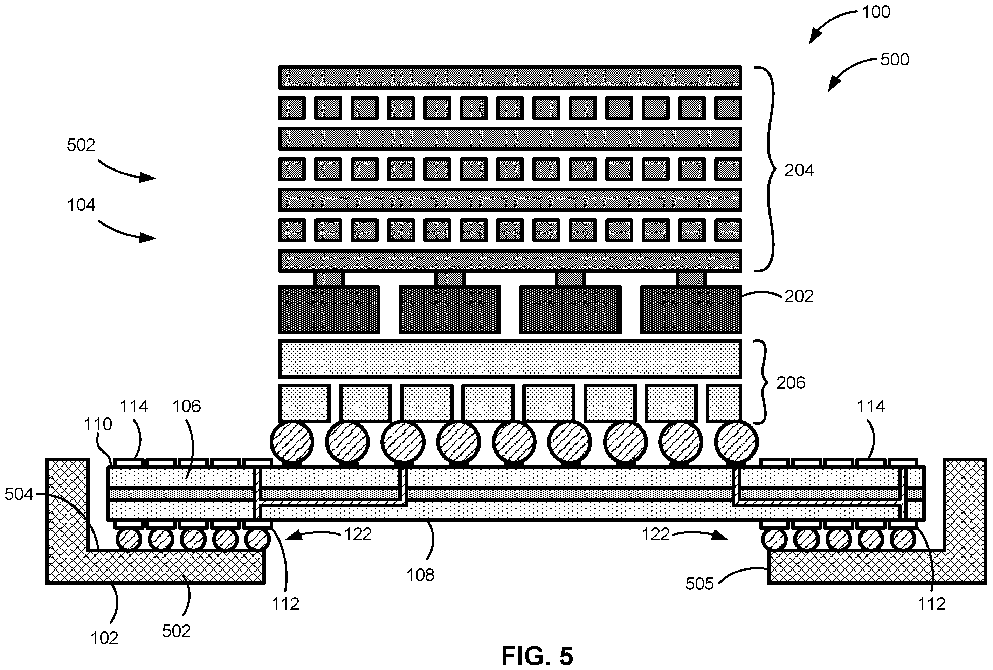

FIG. 5 is a cross-sectional view of the IC package 100 of FIG. 1. The circuit board 102 of the illustrated example includes the socket 122 to receive the IC package 100. The IC package 100 of the illustrated example is electrically coupled to the socket 122 of the circuit board 102 in a first orientation 500. Specifically, the IC package 100 is coupled to the socket 122 via the first contact pads 112 (e.g., lands) of the first surface 108 (e.g., a bottom surface) of the package substrate 106 when the IC package 100 is in the first orientation 500. For instance, in the first orientation 500, the first contact pads 112 are oriented toward the interconnects 122 (e.g., the upper surface 504) of the circuit board 102 and the contact pads 114 are oriented away from the interconnects of the socket 122. In the first orientation 500, the die 104 is positioned in a first or right-side up orientation 502 (e.g., an upright orientation). For instance, the backside metal layers 206 are positioned or oriented beneath the frontside metal layers 204 in the first orientation 500 (e.g., in the orientation of FIG. 5). Thus, the package substrate 106 is in the first or right-side up orientation 502 (e.g., an upright orientation) when coupled to the socket 122 and/or the circuit board 102 via the first contact pads 112. In other words, the die 104 (e.g., the frontside metal layers 204) is positioned above an upper surface 504 of the circuit board 102 (e.g., protrudes from the upper surface 504) when the IC package 100 is in the first orientation 500. Thus, in the first orientation 500, the die 104 protrudes from away from an opening 505 of the socket 122. In the first orientation 500, the first contact pads 112 enable electrical connectivity between the printed circuit board 102 and the die 104 (e.g., via the traces 214 and/or the vias 216 provided in the package substrate 106).

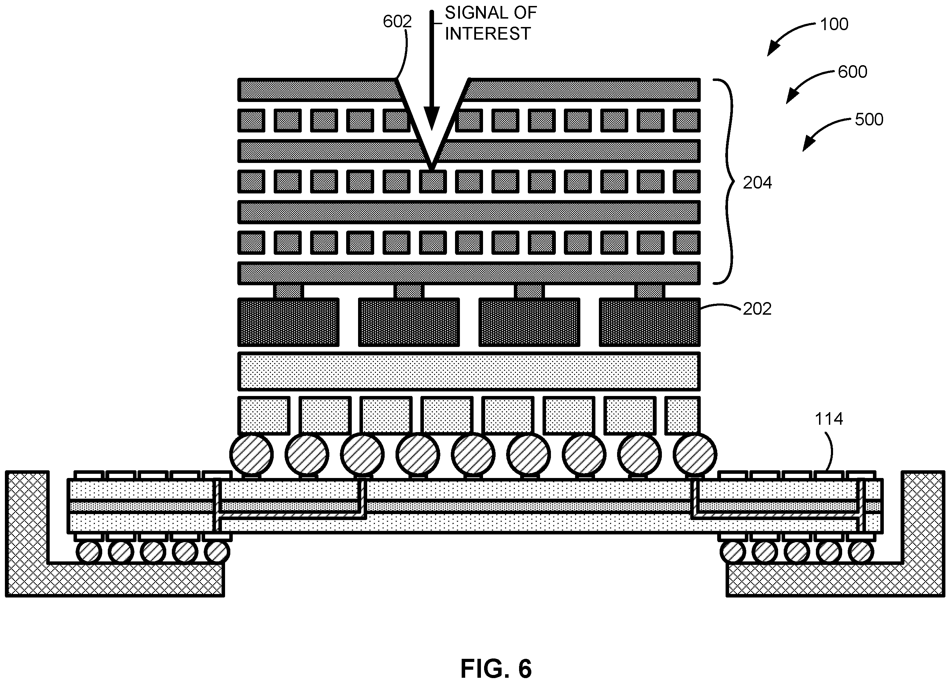

FIG. 6 is a cross-sectional view of the IC package 100 of FIG. 5 in the first orientation 500 during a first testing and/or debugging operation 600. In the illustrated example, a first access opening 602 can be provided (e.g., formed, drilled, machined, etched, etc.) in the frontside metal layers 204 to access or probe one or more transistors 202 positioned underneath the frontside metal layers 204 and/or one or more traces provided by the frontside metal layers 204.

FIG. 7 is a cross-sectional view of the IC package 100 of FIG. 1. The IC package 100 of the illustrated example is electrically coupled to the socket 122 of the circuit board 102 in a second orientation 700. Specifically, the IC package 100 of the illustrated example is coupled to the socket 122 via the second contact pads 114 (e.g., lands) of the second surface 110 (e.g., an upper surface) of the package substrate 106 when the IC package 100 is in the second orientation 700. In the second orientation 700, the die 104 is positioned in a second or upside-down orientation 702. Thus, the package substrate 106 is configured to couple to the circuit board 102 in an upside-down orientation via the second contact pads 114. In other words, the die 104 (e.g., the frontside metal layers 204) is positioned underneath the upper surface 504 of the printed circuit board 102 when the die 104 is in the upside-down orientation 702. For instance, in the second orientation 700, the second contact pads 114 are oriented toward the interconnects 122 of the circuit board 102 and the first contact pads 112 are oriented away from the interconnects 122 of the printed circuit board 102. For instance, the backside metal layers 206 are positioned above the frontside metal layers 204 in the second orientation 700 (e.g., in the orientation of FIG. 7). For instance, in the second orientation 700, the die 104 protrudes through the opening 505 of the socket 122. In the second orientation 700, the second contact pads 114 provide an electrical connectivity between the printed circuit board 102 and the die 104 (e.g., via the traces 214 and the vias 216 of the package substrate 106). Thus, the IC package 100 and/or the package substrate 106 can be flipped between the first orientation 500 (FIG. 5) and the second orientation 700 to couple the IC package 100 to the circuit board 102.

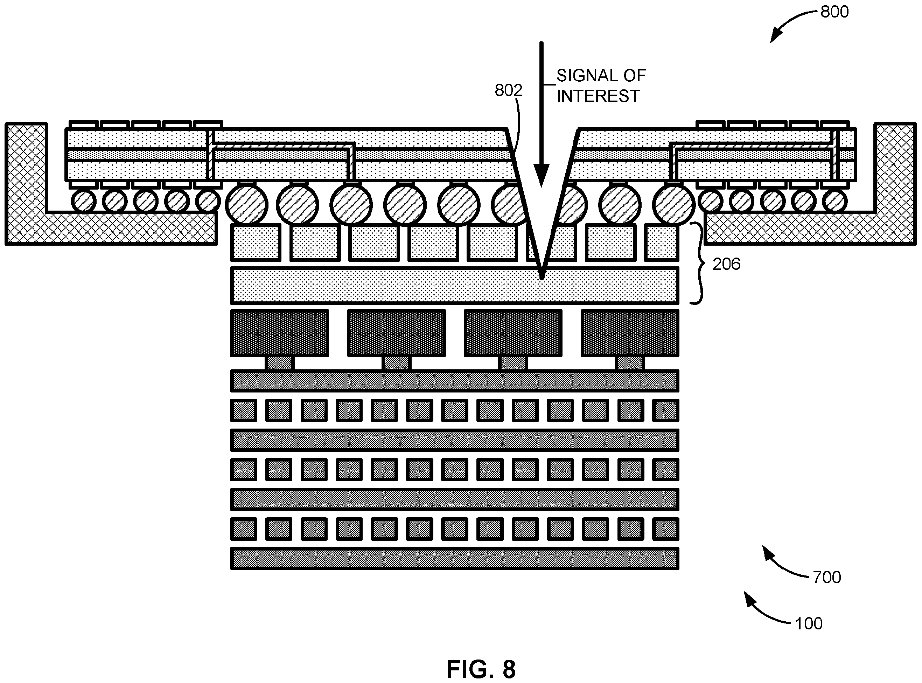

FIG. 8 is a cross-sectional view of the IC package of FIG. 7 shown in the second orientation 700 during a second testing and/or debugging operation 800. In the illustrated example, a second access opening 802 can be provided (e.g., formed, drilled, machined, etched, etc.) in the backside metal layers 206 to access or probe one or more traces positioned in the backside metal layers 206.

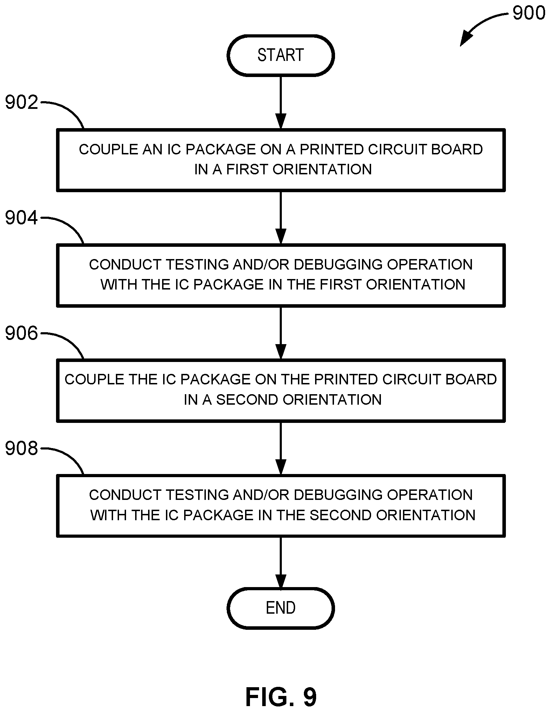

FIG. 9 is a flowchart of an example method 900 of testing the IC package 100 of FIG. 1. While an example manner of testing the example IC package 100 has been illustrated in FIG. 9, one or more of the operations and/or processes illustrated in FIG. 9 may be combined, divided, re-arranged, omitted, eliminated and/or implemented in any other way. Furthermore, the example method of FIG. 8 may include processes and/or operations in addition to, or instead of, those illustrated in FIG. 8 and/or may include more than one of any or all of the illustrated processes and/or operations.

Referring to FIG. 9, the method begins by coupling the IC package 100 to the printed circuit board 102 in the first orientation 500 (block 902). For example, the IC package 100 can be coupled to the socket 122 of the printed circuit board 102 in the first orientation 500 via the first contact pads 112. The first contact pads 112 establish electrical communication between the printed circuit board 102 and the die 104.

In the first orientation 500, testing and/or debugging can be conducted on the IC package 100 with the die 104 in the right-side up orientation 502 (block 904). For example, power can be applied to the IC package 100 via the first contact pads 112 and equipment (e.g., the probes or connectors) can be employed to test and/or debug the IC package 100, the package substrate 106 and/or the die 104. In some examples, one or more access openings (e.g., the first access opening 602 of FIG. 6) can be provided or formed in the die 104 (e.g., the front metal layer 204) to obtain signals and/or measure other parameters associated with the transistors 202 and/or traces of the frontside metal layers 204 of the die 104.

The IC package 100 can be coupled to the printed circuit board 102 in the second orientation 700. (block 906). For example, the IC package 100 can be coupled to the socket 122 of the printed circuit board 102 in the second orientation 700 via the second contact pads 114. The second contact pads 114 establish electrical communication between the printed circuit board 102 and the die 104. In some examples, the IC package 100 can be removed from the socket 122 when in the IC package 100 is in the first orientation 500 and flipped over (e.g., flipped 180 degrees) to the second orientation 700 and recoupled to the socket 122 of the printed circuit board 102 via the second contact pads 114. Such flipping of the IC package 100 does not cause damage to the IC package 100 and can be coupled to the printed circuit board 102. Additionally, the IC package 100 is coupled to the printed circuit board 102 via the second contact pads 114 in the second orientation 700 without use of an interposer and/or other structure.

In the second orientation 700, testing can be conducted on the IC package 100 with the die 104 in the upside-down orientation 702 (block 908). For example, power can be supplied to the IC package 100 via the second contact pads 114 and equipment can be employed to test and/or debug the IC package 100, the package substrate 106 and/or the die 104. In some examples, one or more access openings (e.g., the access opening 802 of FIG. 8) can be provided or formed in the die 104 (e.g., the backside metal layers 206) to obtain signals and/or measure other parameters associated with traces of the backside metal layers 206 of the die 104. In some examples, the IC package 100 can be coupled to the circuit board 102 in the second orientation 700 to perform testing and/or debugging operations prior to (or in lieu of) coupling the IC package 100 to the circuit board 102 in the first orientation 500.

In some examples, testing of the frontside metal layers 204 and testing of the backside metal layers 206 can be performed on the same die or unit. In other words, testing from the frontside metal layers 204 can be performed (e.g., by providing an access opening through the frontside metal layers 204). After testing of the front side metal layers 204, testing can be conducted on the backside metal layers 206 by flipping the package substrate 106 (e.g., 180 degrees). In other examples, a first die can be tested by mounting the first die in the first orientation 500 to a printed circuit board (e.g., the printed circuit board 102) and second die different than the first die can be tested by mounting the second die in the second orientation 700 to a printed circuit board (e.g., the printed circuit board 102). In other words, similar dies can be constructed and tested with similarly constructed printed circuit boards.

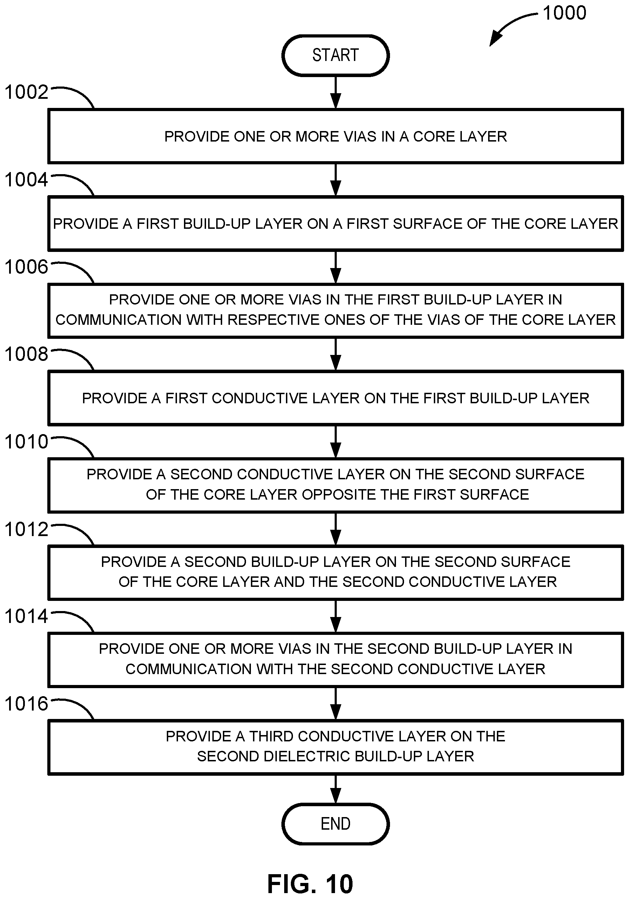

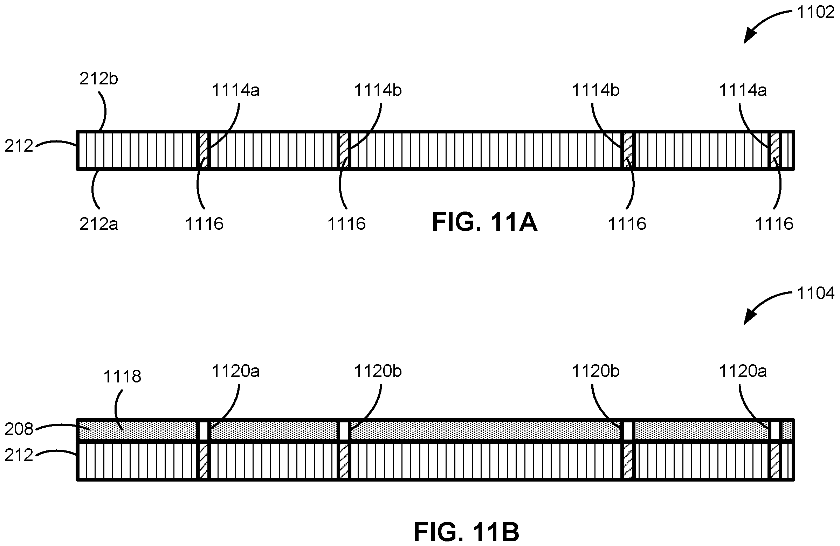

FIG. 10 is a flowchart of an example method 1000 of fabricating an example package substrate (e.g., the package substrate 106 of FIGS. 1-8). To facilitate discussion of the example method 1000, the example method 1000 is described in connection with the example package substrate 106 of FIGS. 1-8. For example, FIGS. 11A-11F are cross-sectional schematic illustrations of the example package substrate 106 of FIGS. 1-8 at various manufacturing stages 1102, 1104, 1106, 1108, 1110, 1112, corresponding to the example method 1000 of FIG. 10. While an example manner of fabricating the example package substrate 106 has been illustrated in FIGS. 10 and 11A-11F, one or more of the operations and/or processes illustrated in FIGS. 10 and 11A-11F may be combined, divided, re-arranged, omitted, eliminated and/or implemented in any other way. Further still, the example methods of FIGS. 10 and 11A-11F may include processes and/or operations in addition to, or instead of, those illustrated in FIGS. 10 and 11A-11F and/or may include more than one of any or all of the illustrated processes and/or operations.

Further, although the example methods are described with reference to the flowchart illustrated in FIG. 10 and the associated manufacturing stages represented in FIGS. 11A-11F, many other methods or processes of fabricating electronic packages may alternatively be used. For example, the package substrate 106 disclosed herein can be provided using conventional manufacturing techniques. For example, some example processes that can be used include laser drilling, laser etching, polishing, photolithography, integrated circuit microfabrication techniques, wet etching, dry etching, anisotropic etching, spin coating, electroforming or electroplating, laser ablation, sputtering, chemical deposition, plasma deposition, surface modification, injection molding, hot embossing, thermoplastic fusion bonding, low temperature bonding using adhesives, stamping, machining, 3-D printing, laminating, and/or any other processes commonly used for manufacture of semiconductor devices.

Referring to the example method 1000 of FIG. 10, the method 1000 begins by providing one or more vias in a core layer (block 1002). For example, referring to FIG. 11A, the core layer 212 can be composed of silicon or glass (e.g., quartz or any other glass material(s)). Additionally, first vias 1114a and second vias 1114b (e.g., through substrate vias (TSVs), through glass vias (TGVs), etc.) can be provided in the core layer 212 between the first surface 212a and the second surface 212b. The number of first vias 1114a corresponds or correlates with a number of the vias 216 of the package substrate 106 of FIG. 2 associated with the first contact pads 112 and the second contact pads 114. The number of second vias 1114b corresponds or correlates with a number of the vias 216 of the package substrate 106 of FIG. 2 associated with third contacts pads 116. Fabrication of the vias 1114a, 1114b can be achieved by any appropriate process including, but not limited to, drilling (e.g., mechanical and/or laser drilling and subsequent cleaning), etching, chemical and/or mechanical polishing, and/or any other through substrate vias (TSVs) and/or through glass vias (TGVs) manufacturing techniques, and/or any other semiconductor manufacturing process(es). After fabrication of the vias 1114a, 1114b of block 1002, the vias 1114a, 1114b of FIG. 11A are filled with a conductive material 1116. The conductive material 1116 can include, but not limited to, copper, aluminum, gold, and/or any other electrically conductive material(s) that can carry or enable passage of electrical current.

Next, a first build-up layer is deposited on the first surface of the core layer (block 1004). For example, referring to FIG. 11B, a first dielectric film 1118 is provided on the second surface 212b of the core layer 212 to provide the first build-up layer 208. The first dielectric film 1118 is deposited on the second surface 212b of the core layer 212. Example dielectric material(s) for providing the first build-up layer 208 can include, but not limited to, titanium dioxide (TiO₂), hafnium dioxide (HfO₂), hafnium zirconium oxide (HZO) (e.g., HZO film), and/or any other suitable dielectric material(s) (e.g., non-conducting material(s) that stores electrical charges). The first build-up layer 208 can be provided on the core layer 212 using conventional semiconductor manufacturing techniques or processes including, but not limited to photolithography, integrated circuit microfabrication techniques, wet etching, dry etching, anisotropic etching, spin coating, electroforming or electroplating, laser ablation, sputtering, chemical deposition, plasma deposition, surface modification, injection molding, hot embossing, thermoplastic fusion bonding, low temperature bonding using adhesives, stamping, machining, 3-D printing, laminating, semi-additive deposition and/or any other processes commonly used for manufacture of semiconductor packages.

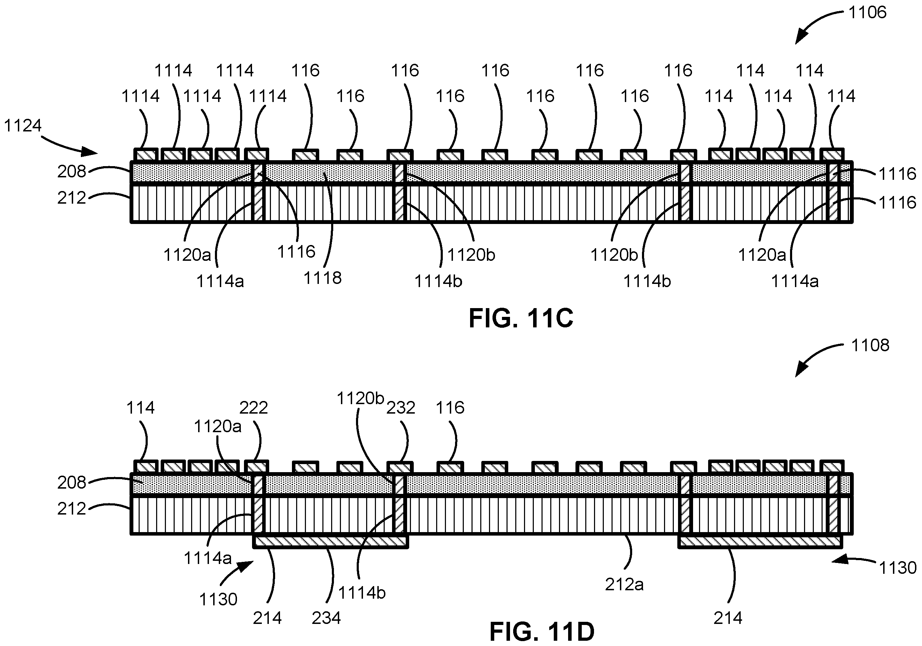

After formation of the first build-up layer, one or more vias are provided in the first build-up layer (block 1006). For example, referring to FIG. 11B, first vias 1120a and second vias 1120b are provided in the first build-up layer 208. Specifically, the first vias 1120a of the first build-up layer 208 align and/or communicate (e.g., electrically couple) with the first vias 1114a of the core layer 212, and the second vias 1120b of the first build-up layer 208 align and/or communicate (e.g., electrically couple) with the second vias 1114b of the core layer 212. Fabrication of the vias 1120a, 1120b can be achieved by any appropriate process including, but not limited to, drilling (e.g., mechanical and/or laser drilling and subsequent cleaning), etching, chemical and/or mechanical polishing, and/or any other through substrate vias (TSVs) manufacturing techniques, and/or any other semiconductor manufacturing process(es). Additionally, the vias 1120a, 1120b of the first build-up layer 208 are filled with the conductive material 1116 (see FIG. 11C).

Next, a first conductive layer is provided on the first build-up layer (block 1008). For example, referring to FIG. 11C, a first conductive layer 1124 is positioned on the first build-up layer 208 to provide the second contact pads 114 and the third contact pads 116. The second contact pads 114 are electrically and/or mechanically coupled to the conductive material 1116 of the first vias 1120a of the first build-up layer 208 and the third contact pads 116 are electrically and/or mechanically coupled to the conductive material 1116 of the second vias 1120b of the first build-up layer 208. The conductive material and/or the first conductive layer 1124 can be electrically conductive material(s) including, but not limited to, copper, aluminum, gold, and/or any other electrically conductive material that can carry or enable passage of electrical current. The first conductive layer 1124 can be provided on the first build-up layer 208 via, for example, a semi-additive process, a build-up film process, etching, lithography and/or any other suitable manufacturing process(es). In some examples, the vias 1120a, 1120b of the first build-up layer 208 can be filled with the application of the first conductive layer 1124 on the first build-up layer 208. In some examples, the vias 1114a, 1114b of the core layer 212 and the vias 1120a, 1120b of the first build-up layer 208 can be filled (e.g., simultaneously, or concurrently) with the application of the first conductive layer 1124 on the first build-up layer 208. In other examples, a plurality of build-up layers can be provided on the package substrate 106.

Next, a second conductive layer is provided on a second surface of the core layer opposite the first surface (block 1010). For example, referring to FIG. 11D, a second conductive layer 1130 is positioned on the first surface 212a of the core layer 212 to provide the traces 214 of the package substrate 106. For example, the first trace 234 electrically and/or mechanically couples a first one of the vias 1114a (e.g., associated with the first one 228 of the vias 216 of FIG. 2) coupled to the first one 222 of the second contact pads 114 and a first one of the vias 1114b (e.g., associated with the third one 236 of the vias 216 of FIG. 2) coupled to the first one 232 of the third contact pads 116. The second conductive layer 1130 can be fabricated from electrically conductive material(s) including, but not limited to, copper, aluminum, gold, and/or any other electrically conductive material that can carry or enable passage of electrical current. The second conductive layer 1130 can be provided on the core layer 212 via, for example, a semi-additive process, a build-up film process, etching, and/or any other suitable manufacturing process(es). For example, the second conductive layer 1130 can be a patterned electroplated copper layer provided or formed via standard semi-additive processes and/or etch hardmask, etc.

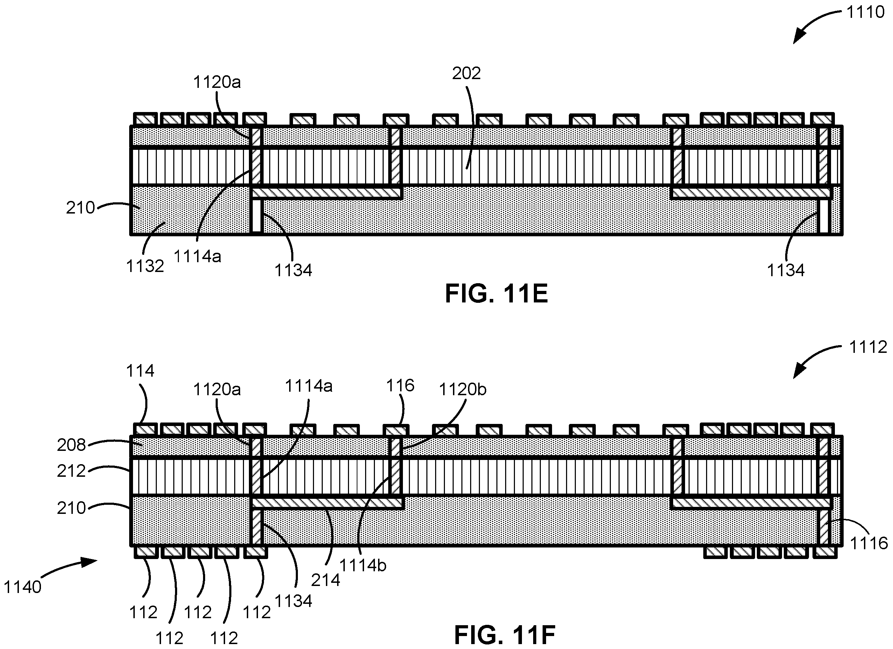

Next, a second build-up layer is provided on a second surface of the core layer and the second conductive layer (block 1012). For example, referring to FIG. 11E, a second dielectric film 1132 is deposited on the first surface 212a of the core layer 212 to provide the second build-up layer 210. Example dielectric materials can include, but not limited to, titanium dioxide (TiO₂), hafnium dioxide (HfO₂), hafnium zirconium oxide (HZO) (e.g., HZO film), and/or any other suitable dielectric material(s) (e.g., non-conducting material(s) that stores electrical charges). The second build-up layer 210 can be provided on the core layer 212 using conventional semiconductor manufacturing techniques or processes including, but not limited to photolithography, integrated circuit microfabrication techniques, wet etching, dry etching, anisotropic etching, spin coating, electroforming or electroplating, laser ablation, sputtering, chemical deposition, plasma deposition, surface modification, injection molding, hot embossing, thermoplastic fusion bonding, low temperature bonding using adhesives, stamping, machining, 3-D printing, laminating, semi-additive deposition and/or any other processes commonly used for manufacture of semiconductor packages.

After providing the second build-up layer, one or more vias are provided in the second build-up layer (block 1014). For example, referring to FIG. 11E, vias 1134 are provided in the second build-up layer 210 that align and/or communicate with (e.g., vertically align and/or electrically couple with) the first vias 1114a of the core layer 212 and/or the first vias 1120a of the first build-up layer 208 associated with the second contact pads 114. Additionally, the vias 1134 of the second build-up layer 210 are filled with the conductive material 1116 (see FIG. 11F).

Next, a third conductive layer is provided on the second build-up layer (block 1016). For example, referring to FIG. 11F, a third conductive layer 1140 is provided on the second build-up layer 210 to provide the first contact pads 112. The third conductive layer 1140 can be fabricated from electrically conductive material(s) including, but not limited to, copper, aluminum, gold, and/or any other electrically conductive material that can carry or enable passage of electrical current. The third conductive layer 1140 can be provided on the second build-up layer 210 via, for example, a semi-additive process, a build-up film process, etching, and/or any other suitable manufacturing process(es). For example, the third conductive layer 1140 can be a patterned electroplated copper layer provided or formed via standard semi-additive processes for the upper or top contact pads 112 and/or etch hardmask, etc. In some examples, the vias 1134 of the second build-up layer 210 can be filled (e.g., simultaneously, or concurrently) with the application of the third conductive layer 1140 on the second build-up layer 210.

As a result, respective ones of the first contact pads 112 are electrically coupled to respective ones of the second contact pads 114 by the vias 216 of the package substrate 106 (e.g., a combination of respective ones of the first vias 1114a, the first vias 1120a, and the vias 1134). Additionally, respective pairs of the first contact pads 112 and the second contact pads 114 are electrically coupled to respective ones of the third contact pads 116 via the traces 214 and the vias 216 (e.g., a combination of the second vias 1114b and the second vias 1120b associated with the third contact pads 116).

"Including" and "comprising" (and all forms and tenses thereof) are used herein to be open ended terms. Thus, whenever a claim employs any form of "include" or "comprise" (e.g., comprises, includes, comprising, including, having, etc.) as a preamble or within a claim recitation of any kind, it is to be understood that additional elements, terms, etc., may be present without falling outside the scope of the corresponding claim or recitation. As used herein, when the phrase "at least" is used as the transition term in, for example, a preamble of a claim, it is open-ended in the same manner as the term "comprising" and "including" are open ended. The term "and/or" when used, for example, in a form such as A, B, and/or C refers to any combination or subset of A, B, C such as (1) A alone, (2) B alone, (3) C alone, (4) A with B, (5) A with C, (6) B with C, or (7) A with B and with C. As used herein in the context of describing structures, components, items, objects and/or things, the phrase "at least one of A and B" is intended to refer to implementations including any of (1) at least one A, (2) at least one B, or (3) at least one A and at least one B. Similarly, as used herein in the context of describing structures, components, items, objects and/or things, the phrase "at least one of A or B" is intended to refer to implementations including any of (1) at least one A, (2) at least one B, or (3) at least one A and at least one B. As used herein in the context of describing the performance or execution of processes, instructions, actions, activities, etc., the phrase "at least one of A and B" is intended to refer to implementations including any of (1) at least one A, (2) at least one B, or (3) at least one A and at least one B. Similarly, as used herein in the context of describing the performance or execution of processes, instructions, actions, activities, etc., the phrase "at least one of A or B" is intended to refer to implementations including any of (1) at least one A, (2) at least one B, or (3) at least one A and at least one B.

As used herein, singular references (e.g., "a", "an", "first", "second", etc.) do not exclude a plurality. The term "a" or "an" object, as used herein, refers to one or more of that object. The terms "a" (or "an"), "one or more", and "at least one" are used interchangeably herein. Furthermore, although individually listed, a plurality of means, elements, or actions may be implemented by, e.g., the same entity or object. Additionally, although individual features may be included in different examples or claims, these may possibly be combined, and the inclusion in different examples or claims does not imply that a combination of features is not feasible and/or advantageous.

As used herein, unless otherwise stated, the term "above" describes the relationship of two parts relative to Earth. A first part is above a second part, if the second part has at least one part between Earth and the first part. Likewise, as used herein, a first part is "below" a second part when the first part is closer to the Earth than the second part. As noted above, a first part can be above or below a second part with one or more of: other parts therebetween, without other parts therebetween, with the first and second parts touching, or without the first and second parts being in direct contact with one another.

Notwithstanding the foregoing, in the case of referencing a semiconductor device (e.g., a transistor), a semiconductor die containing a semiconductor device, and/or an integrated circuit (IC) package containing a semiconductor die during fabrication or manufacturing, "above" is not with reference to Earth, but instead is with reference to an underlying substrate on which relevant components are fabricated, assembled, mounted, supported, or otherwise provided. Thus, as used herein and unless otherwise stated or implied from the context, a first component within a semiconductor die (e.g., a transistor or other semiconductor device) is "above" a second component within the semiconductor die when the first component is farther away from a substrate (e.g., a semiconductor wafer) during fabrication/manufacturing than the second component on which the two components are fabricated or otherwise provided. Similarly, unless otherwise stated or implied from the context, a first component within an IC package (e.g., a semiconductor die) is "above" a second component within the IC package during fabrication when the first component is farther away from a printed circuit board (PCB) to which the IC package is to be mounted or attached. It is to be understood that semiconductor devices are often used in orientation different than their orientation during fabrication. Thus, when referring to a semiconductor device (e.g., a transistor), a semiconductor die containing a semiconductor device, and/or an integrated circuit (IC) package containing a semiconductor die during use, the definition of "above" in the preceding paragraph (i.e., the term "above" describes the relationship of two parts relative to Earth) will likely govern based on the usage context.

As used in this patent, stating that any part (e.g., a layer, film, area, region, or plate) is in any way on (e.g., positioned on, located on, disposed on, or formed on, etc.) another part, indicates that the referenced part is either in contact with the other part, or that the referenced part is above the other part with one or more intermediate part(s) located therebetween.

As used herein, connection references (e.g., attached, coupled, connected, and joined) may include intermediate members between the elements referenced by the connection reference and/or relative movement between those elements unless otherwise indicated. As such, connection references do not necessarily infer that two elements are directly connected and/or in fixed relation to each other. As used herein, stating that any part is in "contact" with another part is defined to mean that there is no intermediate part between the two parts.

Unless specifically stated otherwise, descriptors such as "first," "second," "third," etc., are used herein without imputing or otherwise indicating any meaning of priority, physical order, arrangement in a list, and/or ordering in any way, but are merely used as labels and/or arbitrary names to distinguish elements for ease of understanding the disclosed examples. In some examples, the descriptor "first" may be used to refer to an element in the detailed description, while the same element may be referred to in a claim with a different descriptor such as "second" or "third." In such instances, it should be understood that such descriptors are used merely for identifying those elements distinctly within the context of the discussion (e.g., within a claim) in which the elements might, for example, otherwise share a same name.

As used herein, "approximately" and "about" modify their subjects/values to recognize the potential presence of variations that occur in real world applications. For example, "approximately" and "about" may modify dimensions that may not be exact due to manufacturing tolerances and/or other real world imperfections as will be understood by persons of ordinary skill in the art. For example, "approximately" and "about" may indicate such dimensions may be within a tolerance range of +/- 10% unless otherwise specified herein.

As used herein, the phrase "in communication," including variations thereof, encompasses direct communication and/or indirect communication through one or more intermediary components, and does not require direct physical (e.g., wired) communication and/or constant communication, but rather additionally includes selective communication at periodic intervals, scheduled intervals, aperiodic intervals, and/or one-time events.

As used herein, "programmable circuitry" is defined to include (i) one or more special purpose electrical circuits (e.g., an application specific circuit (ASIC)) structured to perform specific operation(s) and including one or more semiconductor-based logic devices (e.g., electrical hardware implemented by one or more transistors), and/or (ii) one or more general purpose semiconductor-based electrical circuits programmable with instructions to perform specific functions(s) and/or operation(s) and including one or more semiconductor-based logic devices (e.g., electrical hardware implemented by one or more transistors). Examples of programmable circuitry include programmable microprocessors such as Central Processor Units (CPUs) that may execute first instructions to perform one or more operations and/or functions, Field Programmable Gate Arrays (FPGAs) that may be programmed with second instructions to cause configuration and/or structuring of the FPGAs to instantiate one or more operations and/or functions corresponding to the first instructions, Graphics Processor Units (GPUs) that may execute first instructions to perform one or more operations and/or functions, Digital Signal Processors (DSPs) that may execute first instructions to perform one or more operations and/or functions, XPUs, Network Processing Units (NPUs) one or more microcontrollers that may execute first instructions to perform one or more operations and/or functions and/or integrated circuits such as Application Specific Integrated Circuits (ASICs). For example, an XPU may be implemented by a heterogeneous computing system including multiple types of programmable circuitry (e.g., one or more FPGAs, one or more CPUs, one or more GPUs, one or more NPUs, one or more DSPs, etc., and/or any combination(s) thereof), and orchestration technology (e.g., application programming interface(s) (API(s)) that may assign computing task(s) to whichever one(s) of the multiple types of programmable circuitry is/are suited and available to perform the computing task(s).

As used herein integrated circuit/circuitry is defined as one or more semiconductor packages containing one or more circuit elements such as transistors, capacitors, inductors, resistors, current paths, diodes, etc. For example, an integrated circuit may be implemented as one or more of an ASIC, an FPGA, a chip, a microchip, programmable circuitry, a semiconductor substrate coupling multiple circuit elements, a system on chip (SoC), etc.

From the foregoing, it will be appreciated that example systems, methods, apparatus, and articles of manufacture have been disclosed that improve and/or facilitate testing and/or debugging of dies and/or IC package apparatus. Examples disclosed herein reduce costs and/or time associated with testing and/or debugging operations.

Example methods, apparatus, systems, and articles of manufacture to provide IC package apparatus are disclosed herein. Further examples and combinations thereof include the following:
Example 1 includes an apparatus comprising an integrated circuit package including a die, and a package substrate having a first surface and a second surface opposite the first surface, the die coupled to the first surface, the first surface including a plurality of first contact pads and the second surface including a plurality of second contact pads, the first contact pads spaced apart from the die, the first contact pads and the second contact pads being electrically coupled with the die.
Example 2 includes the apparatus of example 1, where the second contact pads are provided on the second surface outside of a perimeter defined by the die.
Example 3 includes the apparatus of any one of examples 1 or 2, where the package substrate includes a plurality of third contact pads provided on the second surface, the die coupled to the package substrate via the third contact pads.
Example 4 includes the apparatus of any one of examples 1-3, where the package substrate includes a plurality of vias and a plurality of traces, respective ones of the first contact pads and respective ones of the second contact pads are electrically coupled to respective ones of the third contact pads by respective ones of the vias and respective ones of the traces provided by the package substrate.
Example 5 includes the apparatus of any one of examples 1-4, where the third contact pads are positioned within a perimeter defined by the die and the second contact pads are provided outside of the perimeter defined by the die.
Example 6 includes the apparatus of any one of examples 1-5, further including a printed circuit board having a socket to receive the integrated circuit package.
Example 7 includes the apparatus of any one of examples 1-6, where the package substrate is configured to couple to the printed circuit board in a first orientation via the first contact pads.
Example 8 includes the apparatus of any one of examples 1-7, where the package substrate is configured to couple to the printed circuit board in a second orientation different than the first orientation via the second contact pads.
Example 9 includes the apparatus of any one of examples 1-8, where the first contact pads provide an electrical connection between the printed circuit board and the die when the package substrate is coupled to the socket in the first orientation, and where the second contact pads provide an electrical connection between the printed circuit board and the die when the package substrate is coupled to the socket in the second orientation.
Example 10 includes an apparatus comprising a die having a plurality of transistors between a first metal layer and a second metal layer, the first metal layer adjacent a first side of the die, the second metal layer adjacent a second side of the die opposite the first side of the die. A package substrate includes a first surface, first contact pads provided on the first surface, a second surface opposite the first surface, second contact pads provided on the second surface, third contact pads provided on the second surface, the die coupled to the second surface of the package substrate via the third contact pads, the second side of the die to face towards the package substrate a plurality of vias provided between the first surface and the second surface, a plurality of traces provided between the first surface and the second surface, and a printed circuit board having a socket to receive the package substrate.
Example 11 includes the apparatus of example 10, wherein the package substrate is configured to couple to a surface of the socket via the second contact pads such that the die is oriented in a first orientation in which the first side of the die faces in an opposite direction to which the surface of the socket faces.
Example 12 includes the apparatus of examples 10 or 11, wherein the die extends through an opening in the printed circuit board when the die is in the first orientation.
Example 13 includes the apparatus of any one of examples 10-12, wherein a first one of the first contact pads is electrically coupled to a second one of the second pads by a first one of the vias provided in the package substrate.
Example 14 includes the apparatus of any one of examples 10-13, wherein a first one of the third contact pads is coupled to a second one of the vias provided in the package substrate.
Example 15 includes the apparatus of any one of examples 10-14, wherein the first one of the vias and the second one of the vias are electrically coupled by a first one of the traces provided in the package substrate.
Example 16 includes the apparatus of any one of examples 10-15, wherein respective ones of the first contact pads are electrically coupled to respective ones of the second contact pads by respective ones of the vias.
Example 17 includes the apparatus of any one of examples 10-16, wherein respective ones of the third contact pads are electrically coupled to the respective ones of the first contact pads and the respective ones of the second contact pads by respective ones of the traces of the package substrate.
Example 18 includes a method to test an integrated circuit package, the method comprising providing a package substrate having a first set of first pads on a first surface of the package substrate, a second set of second pads on a second surface opposite the first surface, and a third set of pads on the second surface, coupling a die to the third set of pads on the second surface via interconnects, and coupling the package substrate to a socket of a printed circuit board using either the first set of pads on the first surface such that the die is oriented in a first orientation or the second set of pads on the second surface such that the die is oriented in a second orientation.
Example 19 includes the method of example 18, further including providing an access opening in a first metal layer of the die to access at least one of a metal interconnect inside the die or a transistor of the die when the die is in the first orientation.
Example 20 includes the method of examples 18 or 19, further including providing an access opening in a second metal layer of the die to access at least one of a metal interconnect inside the die or a transistor of the die when the die is in the second orientation.

The following claims are hereby incorporated into this Detailed Description by this reference. Although certain example systems, apparatus, articles of manufacture, and methods have been disclosed herein, the scope of coverage of this patent is not limited thereto. On the contrary, this patent covers all systems, apparatus, articles of manufacture, and methods fairly falling within the scope of the claims of this patent.

## Claims

1. An apparatus comprising:
an integrated circuit package including:
a die; and
a package substrate having a first surface and a second surface opposite the first surface, the die coupled to the first surface, the first surface including a plurality of first contact pads and the second surface including a plurality of second contact pads, the first contact pads spaced apart from the die, the first contact pads and the second contact pads being electrically coupled with the die.

2. The apparatus of claim 1, wherein the second contact pads are provided on the second surface outside of a perimeter defined by the die.

3. The apparatus of any one of claims 1 or 2, wherein the package substrate includes a plurality of third contact pads provided on the second surface, the die coupled to the package substrate via the third contact pads.

4. The apparatus of claim 3, wherein the package substrate includes a plurality of vias and a plurality of traces, respective ones of the first contact pads and respective ones of the second contact pads being electrically coupled to respective ones of the third contact pads by respective ones of the vias and respective ones of the traces provided by the package substrate.

5. The apparatus of claim 3, wherein the third contact pads are positioned within a perimeter defined by the die and the second contact pads are provided outside of the perimeter defined by the die.

6. The apparatus of claim 4, wherein the plurality of vias and the plurality of traces are provided between the first surface and the second surface of the package substrate.

7. The apparatus of any one of claims 1-6, further including a printed circuit board having a socket to receive the integrated circuit package.

8. The apparatus of claim 7, wherein the package substrate is configured to couple to the printed circuit board in a first orientation via the first contact pads.

9. The apparatus of claim 8, wherein the package substrate is configured to couple to the printed circuit board in a second orientation different than the first orientation via the second contact pads.

10. The apparatus of claim 9, wherein the first contact pads provide an electrical connection between the printed circuit board and the die when the package substrate is coupled to the socket in the first orientation, and wherein the second contact pads provide an electrical connection between the printed circuit board and the die when the package substrate is coupled to the socket in the second orientation.

11. The apparatus of claim 8, wherein the die extends through an opening in the printed circuit board when the package substrate is in the first orientation.

12. The apparatus of any one of claims 1-11, wherein the die has a plurality of transistors between a first metal layer and a second metal layer, the first metal layer adjacent a first side of the die, the second metal layer adjacent a second side of the die opposite the first side of the die.

13. A method to test an integrated circuit package, the method comprising:
providing a package substrate having a first set of first pads on a first surface of the package substrate, a second set of second pads on a second surface opposite the first surface, and a third set of pads on the second surface;
coupling a die to the third set of pads on the second surface via interconnects; and
coupling the package substrate to a socket of a printed circuit board using either the first set of pads on the first surface such that the die is oriented in a first orientation or the second set of pads on the second surface such that the die is oriented in a second orientation different than the first orientation.

14. The method of claim 13, further including providing an access opening in a first metal layer of the die to access at least one of a metal interconnect inside the die or a transistor of the die when the die is in the first orientation.

15. The method of any one of claims 13 or 14, further including providing an access opening in a second metal layer of the die to access at least one of a metal interconnect inside the die or a transistor of the die when the die is in the second orientation.
